# EUROPEAN PATENT APPLICATION

(11) **EP 4 664 530 A1**
(43) Date of publication of application: **17.12.2025**
(21) Application number: 24181590.1
(22) Date of filing: 12.06.2024
(51) Int. Cl.: H01L 29/06, H01L 27/06, H01L 29/423, H01L 29/786, H10B 12/00

(54) **AN INTEGRATED DRAM DEVICE INCLUDING A DRAM AND A LOGIC CIRCUIT**

(71) Applicant: Imec VZW, 3001 Leuven (BE)
(72) Inventor: Baudot, Sylvain, 1200 Woluwe Saint-Lambert (BE); Hellings, Geert, 1500 Halle (BE)
(74) Representative: Roth, Sebastian

(57) **Abstract**

This disclosure relates to dynamic random access memory (DRAM). The disclosure provides an integrated DRAM device including a DRAM and a logic circuit for controlling the dram. The DRAM device may be based on nanosheet transistor technology and/or complementary field effect transistor (CFET) technology. The DRAM device comprises a plurality of stacked transistors arranged in a first region of the DRAM device one above another along a stacking direction, and a storage capacitor arranged in a second region of the DRAM device. The first region is arranged above the second region along the stacking direction. A transistor of the plurality of stacked transistors is connected to the storage capacitor to form a DRAM cell of the DRAM, and the remaining transistors are part of the logic circuit.

## Description

### TECHNICAL FIELD

The present disclosure relates to dynamic random access memory (DRAM). The disclosure provides an integrated DRAM device, which comprises a DRAM and a logic circuit for controlling the DRAM. The DRAM device may be based on nanosheet transistor technology and/or may use complementary field effect transistor (CFET) technology. The DRAM device of this disclosure maybe obtained by forming a wafer backside integrated DRAM on a CFET structure.

### BACKGROUND

System-Technology Co-Optimization (STCO) is an approach that aims for optimizing both system level design and semiconductor technology. Unlike conventional approaches that optimize components separately, STCO involves simultaneous co-design and co-optimization of the components, so as to leverage synergies to enhance performance and scalability.

In particular, STCO thus offers potential for future scaling road maps of DRAM devices. One advantage is that STCO may allow integrating DRAMs with logic circuits in integrated DRAM devices. Conventionally, this is done by either 3D integrating separate chips together, or by using a separate chip area for fabricating the logic circuit.

However, the 3D integration of separate chips involves a high complexity, and requires connecting the DRAM to the logic circuit via through-silicon vias (TSVs). Using separate chips for the DRAM and the logic circuit also comes with a performance penalty, particularly, with longer timing delays due to additional routing. Using a separate chip area for fabricating the logic circuit enlarges the chip, and also increases its costs.

### SUMMARY

In view of the above, an objective of this disclosure is therefore to provide a new approach for an integrated DRAM device, which integrates a DRAM and a logic circuit for controlling the DRAM. In particular, an objective is to design a DRAM device with low complexity. Another particular objective is to obtain a compact DRAM device. Also a cost reduction for fabricating the DRAM device is an objective of this disclosure. Another objective is to reduce a timing delay.

These and other objectives are achieved by the solutions provided in the independent claims. Advantageous implementations are described in the dependent claims.

A first aspect of this disclosure relates to an integrated DRAM device including a DRAM and a logic circuit for controlling the DRAM, wherein the DRAM device comprises: a plurality of stacked transistors arranged in a first region of the DRAM device one above another along a stacking direction; a storage capacitor arranged in a second region of the DRAM device, wherein the first region is arranged above the second region along the stacking direction; wherein a particular transistor of the plurality of stacked transistors is connected to the storage capacitor to form a DRAM cell of the DRAM; and wherein the remaining transistors of the plurality of stacked transistors are part of the logic circuit.

The DRAM device of the first aspect integrates the DRAM and the logic circuit. For instance, the DRAM and the logic circuit may be monolithically integrated. The DRAM device does not require TSVs to connect the DRAM and the logic circuit. The DRAM may be fabricated directly into a substrate or a substrate layer, on which the logic circuit is fabricated, e.g., by backside integration of the storage capacitor of the DRAM cell into the substrate of the stacked transistors. The substrate may be a wafer.

In this way, the DRAM device can be built compact and has a low complex design. No additional area is required for the DRAM, as it maybe monolithically integrated with the transistors of the logic circuit. Thus, its fabrication costs can be reduced as well. Moreover, by placing the DRAM cell next to the logic circuit, a timing delay may be reduced.

Notably, the stacked transistors may be formed by stacked transistor channels (e.g., made of a semiconductor material), which are surrounded by a gate structure (e.g., a gate-all around (GAA) structure). The stacked transistors may be formed in a conventional way on the wafer or substrate, before the DRAM is processed. The particular transistor may be the lowest/bottom-most transistor of the stacked transistors, that is, the one closest to the second region/wafer/substrate.

In an implementation of the DRAM device, the second region is a substrate layer of the DRAM device, and the storage capacitor is embedded in the substrate layer.

In this way, a compact DRAM device is achieved. Also a fabrication process may be simplified. The integration offers further advantages, like shorter connections or avoiding of vias.

In an implementation of the DRAM device, the particular transistor is connected with its drain to a first metal structure of the storage capacitor.

In an implementation of the DRAM device, the storage capacitor further comprises a second metal structure, wherein the first metal structure is arranged above the second metal structure along the stacking direction; and a dielectric layer separating and isolating the second metal structure from the first metal structure.

The two metal structures function as the capacitor plates of the storage capacitor.

In an implementation of the DRAM device, the second metal structure is connected to a ground line of the DRAM device; and the second region is arranged above the ground line along the stacking direction.

In an implementation, the DRAM device further comprises a bit line contact formed in the second region, connected to a source of the particular transistor, and connected to a bit line of the DRAM device; wherein the second region is arranged above at least a part of the bit line along the stacking direction.

In an implementation of the DRAM device, a gate of the particular transistor is connected to an address line of the DRAM device.

In an implementation of the DRAM device, at least a part of the address line is arranged above the first region along the stacking direction.

In an implementation, the DRAM device further comprises a gate contact arranged in the second region, connected to the gate of the particular transistor, and connected to the address line; wherein the second region is arranged above at least a part of the address line along the stacking direction.

In an implementation of the DRAM device, the first region and the second region are monolithically integrated. This offers advantages of size reduction, improved performance due to shorter connections and lower parasitic resistances and capacitances, lower power consumption, increased reliability, and cost efficiency.

In an implementation of the DRAM device, the stacked transistors are nanosheet transistors; and/or the remaining transistors comprise a set of n-type transistors and a set of p-type transistors of a complementary field effect transistor, CFET.

The nanosheet transistors may be formed by stacked nanosheet (channels) with a GAA structure surrounding them. The nanosheet transistors may be formed in a conventional way. Other stacked transistors may be used. The transistors could also be FinFETs.

A second aspect of this disclosure relates to a method for fabricating an integrated DRAM device including a DRAM and a logic circuit for controlling the DRAM, wherein the method comprises: forming a plurality of stacked transistors in a first region of the DRAM device one above another along a stacking direction; forming a storage capacitor in a second region of the DRAM device, wherein the first region is formed above the second region along the stacking direction; wherein a particular transistor of the plurality of stacked transistors is connected to the storage capacitor to form a DRAM cell of the DRAM; and wherein the remaining transistors of the plurality of stacked transistors are formed as part of the logic circuit.

In an implementation of the method, the second region is a substrate layer; the first region is formed on a front-surface of and above the substrate layer; and the storage capacitor is processed into the substrate layer from a back-surface of the substrate layer.

In an implementation of the method, the storage capacitor is formed self-aligned with the particular transistor, by etching a sacrificial plug adjacent to a source and a drain of the particular transistor, and by filling a first metal of the storage capacitor into a space resulting from the etching of the sacrificial plug; and/or the storage capacitor is formed near the particular transistor instead of vias connected to the source and the drain of the particular transistor with the first metal.

The self-alignment facilitates the fabrication process, and improves the performance and reliability of the DRAM device.

In an implementation of the method, the method further comprises forming a bit line contact and optionally a gate contact in the second region; wherein the bit line contact is connected to a source of the particular transistor, and the gate contact, if present, is connected to a gate of the particular transistor.

The method of the second aspect generally achieves the same advantages as described for the DRAM device of the first aspect, and may be extended by respective implementations similar to those described above for the DRAM device of the first aspect.

In summary, this disclosure proposes forming a storage capacitor connected to - and preferably self-aligned with - a particular transistor of a plurality of stacked transistors, for instance, of a CFET structure. The storage capacitor and the particular transistor - e.g. the lowest transistor of the CFET structure - form a DRAM cell of the DRAM, and the other stacked transistors may be used for the logic circuit that controls the DRAM. The formation of the DRAM directly below the stacked transistors integrates the DRAM with the logic circuit.

### BRIEF DESCRIPTION OF THE DRAWINGS

The above described aspects and implementations are explained in the following description of embodiments with respect to the enclosed drawings:
- FIG. 1: shows a DRAM device according to this disclosure.
- FIGs. 2-9: show a first processing sequence for fabricating a DRAM device according to this disclosure.
- FIGs. 10-17: show a second processing sequence for fabricating a DRAM device according to this disclosure.
- FIG. 18: shows exemplary implementations and explanation of elements and materials of the DRAM device according to this disclosure.
- FIG. 19: shows a schematic circuit of a DRAM cell of a DRAM device according to this disclosure.
- FIG. 20: shows a flow-diagram of a general method for fabricating a DRAM device according to this disclosure.

### DETAILED DESCRIPTION OF EMBODIMENTS

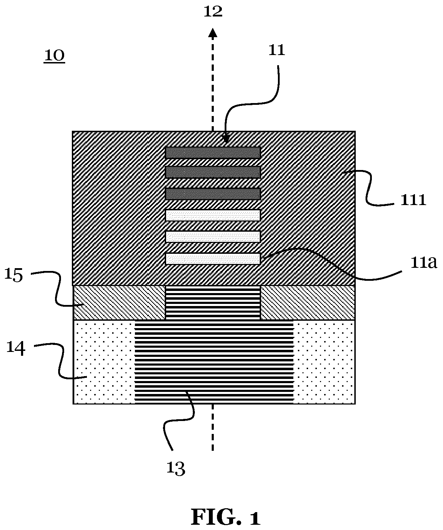

FIG. 1 shows an integrated DRAM, device 10 according to this disclosure. The DRAM device 10 includes a DRAM and a logic circuit. The DRAM and the logic circuit are integrated. The DRAM comprises at least one DRAM cell, but usually many. The logic circuit is configured to control the DRAM. For instance, the logic circuit may control at least one of the following operations of the DRAM: address decoding, read/write, refresh control, data buffering. Thereby, address decoding determines the specific DRAM cell, from which to read or to which to write by decoding an address. Read/write control manages the timing and control signals for reading data from, or writing data to, the DRAM cells. Refresh control periodically refreshes the data stored in the DRAM cells to prevent data loss due to charge leakage. Data Buffering handles the transfer of data between the DRAM and, for example, a CPU or other components, ensuring data integrity and proper timing.

The DRAM device 10 comprises a plurality of stacked transistors 11, which are arranged in a first region of the DRAM device 10 one above another along a stacking direction 12. The stacking direction 12 maybe a growth direction. The first region may correspond to a region, in which a gate-all-around (GAA) structure 111 of the stacked transistors 11 is arranged (around stacked channels of the transistors 11). The stacked transistors 11 maybe nanosheet transistors, i.e., the channels may be nanosheets. The stacked transistors 11 may comprise n-type transistors and p-type transistors (e.g., as exemplarily distinguished in FIG. 1 by the different grey-scales), and may form together a CFET structure.

The GAA structure 111 may comprise a high-k material and metal gate material (HKMG) like titanium nitride (TiN), and additionally tungsten (W) may be deposited on top of the TiN. The GAA structure 111 may thus comprise and be referred to as HKMG+W. Notably, to be precise, the stacked transistors 11 include the stacked channels of the transistors 11 and also include the GAA structure 111, or another gate structure, including a gate dielectric and metal.

The DRAM device 10 further comprises a storage capacitor 13, which is arranged in a second region of the DRAM device 10. The second region may be a region of a substrate (used interchangeably with "wafer" in this disclosure) or a substrate layer 14 (e.g., a layer on a substrate/wafer) of the DRAM device 10. The storage capacitor 13 may be embedded in the substrate layer 14. The storage capacitor 13 may be fabricated by processing from the backside (back-surface) of the substrate layer 14 (and/or the substrate/wafer) into the substrate layer 14. The first region is arranged above the second region along the stacking direction, for instance, the GAA structure 111 may be arranged above the substrate layer 14 in the denomination used in this disclosure. The first region and the second region may be monolithically integrated, as shown in FIG. 1.

A particular transistor 11a of the plurality of stacked transistors 11 - preferably the lowest transistor 11a of the stacked transistors 11, i.e., the transistor 11a that is closest to the second region - is connected to the storage capacitor 13. The storage capacitor 13 and the particular transistor 11a form a DRAM cell of the DRAM. Accordingly, FIG. 1 may be considered showing a unit cell of the DRAM device 10. Obviously, a DRAM typically has more than one DRAM cell, and for each DRAM cell of the DRAM, the unit cell shown in FIG. 1 may be repeated.

The remaining transistors 11 of the plurality of stacked transistors 11 are part of the logic circuit. This may notably be the case for each repetition of the unit cell. Thus the logic circuit can comprise many transistors, and multiple stacks, which can be used to control the DRAM with all of its DRAM cells. The logic circuit may, however, also take over other processing steps of the DRAM device. Notably, the remaining transistors 11 may still comprise a set of n-type transistors and a set of p-type transistors of a CFET structure.

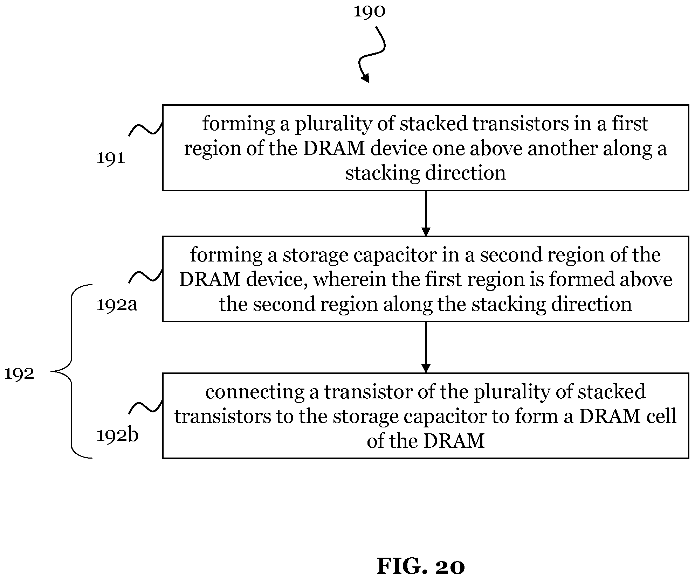

FIG. 20 shows a flow-diagram of a general method 190 for fabricating the DRAM device 10 according to this disclosure. The method 190 is particularly suitable for fabricating the DRAM device 10 of FIG. 1.

The method comprises a step 191 of forming the plurality of stacked transistors 11 in the first region of the DRAM device 10, one above another along the stacking direction 12. The method 190 further comprises a step 192, which comprises forming 192a the storage capacitor 13 in the second region of the DRAM device 10, and thereby connecting 192b the particular transistor 11a of the plurality of stacked transistors 11 to the storage capacitor 13, to form the DRAM cell of the DRAM. The remaining transistors 11 of the plurality of stacked transistors 11 are formed as part of the logic circuit.

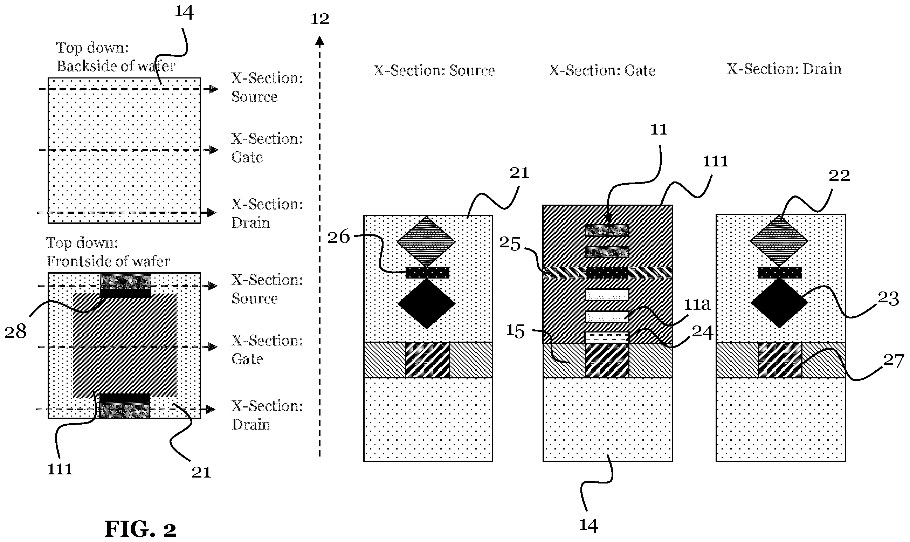

FIGs. 2-9 show a first processing sequence for fabricating a DRAM device 10 according to this disclosure. The first processing sequence is based on the method 190. The first processing sequence forms a gate connection from the front-side.

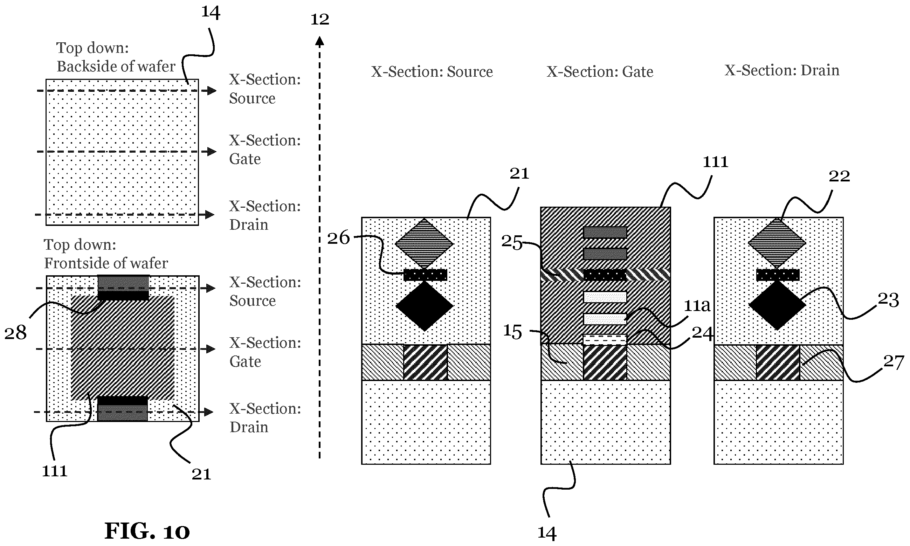

FIGs. 10-17 show a second processing sequence for fabricating a DRAM device 10 according to this disclosure. The second processing sequence bases also on the method 190. The second processing sequence - in contrast to the first processing sequence - forms all connections, including the gate connection, from the backside of the wafer/substrate 14.

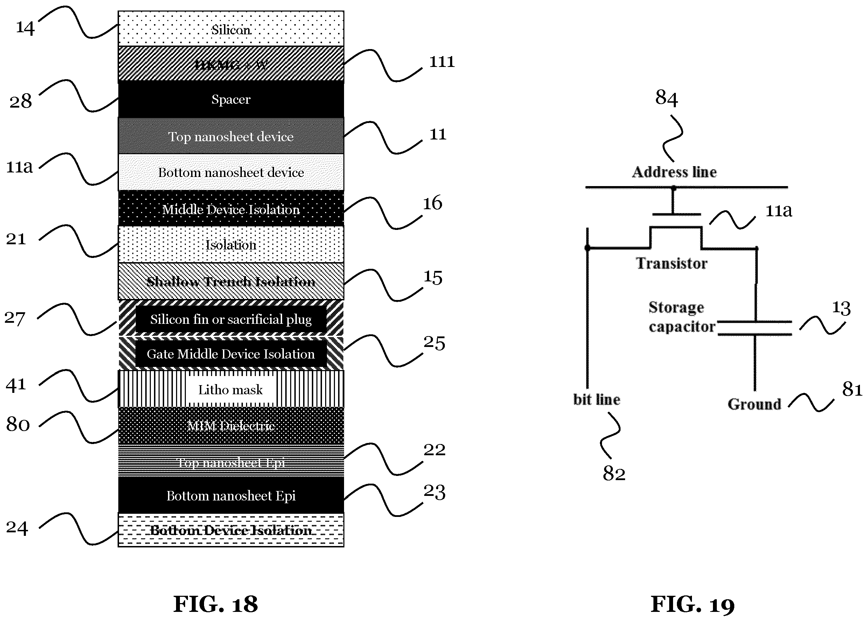

In the FIGs. 2-17, various elements of the DRAM device 10, or respectively its intermediate versions, are indicated with different grey-scales and shadings. An exemplary explanation of these elements is shown in FIG. 18, wherein the same grey-scales and shadings are used.

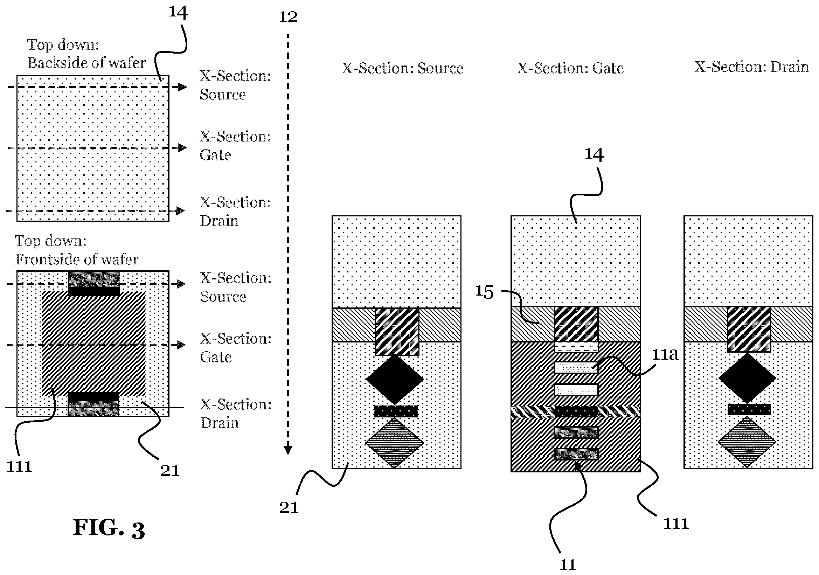

FIG. 2 shows an initial structure for starting the first processing sequence. The initial structure is shown in various views, particularly, in a top-down view of the backside of the substrate/wafer, in a top-down view of the front side of the substrate/wafer, in a view along a cross-section (X-section) through the source, in a view along a X-section through the gate, and in a view along the X-section through the drain. The same views are used in the FIGs. 3-17 to illustrate the first processing sequence and the second processing sequence, respectively.

The initial structure in FIG. 2 includes the substrate 14 (or substrate layer, in any case here the same as a wafer), for example made of silicon or silicon-based material, and includes a plurality of stacked transistors 11 formed above the substrate 14. More precisely, a plurality of transistor channels are stacked and the reference sign 11 points to the channels. A GAA structure 111 surrounds the channels. The initial structure may have been processed according to conventional processing techniques, for example, nanosheet transistor fabrication processes. Accordingly, the plurality of stacked transistors 11 may - as illustrated in FIG. 2 - be stacked nanosheet transistors, and may moreover be formed as a CFET structure, which includes both n-type and p-type nanosheet transistors (different grey-scales show this here, just as example). The stacked transistors 11, in particular, include top transistors 11 and bottom transistors 11, for example, the bottom-most transistor 11a (closest to the substrate 14). The top and bottom transistors 11 are separated from each other by a middle device isolation (MDI) 26 and a gate MDI 25. In the example of FIG. 2, the top transistors and bottom transistors form the CFET structure, wherein the transistors have a different majority carrier type (electron or hole) present in the source/drain region and in the channel. The transistors 11 may all be surrounded by the GAA structure 111, which may comprise HKMG+W, as described above. The GAA structure 111 is further separated from the substrate 14 by a shallow trench isolation (STI) 15, in which a silicon fin or sacrificial plug 27 is formed and is aligned with the (channels of the) stacked transistors 11. The GAA structure 111 may be partly surrounded by an isolation 21. The transistors 11 are further contacted by epitaxial regions (epi-regions) 22 and 23, respectively, for the top and the bottom transistors 11. These epi-regions 22, 23 may be made from highly doped semiconductor material, and are positioned at either end of the transistor channels, so as to implement source and drain regions. A spacer 28 may be provided between the GAA structure 111 and the source/drain regions of the transistors 11.

FIG. 3 shows a first step of the first processing sequence. In the first step, the initial structure is flipped, and then a partial polish of the backside of the substrate 14 is performed.

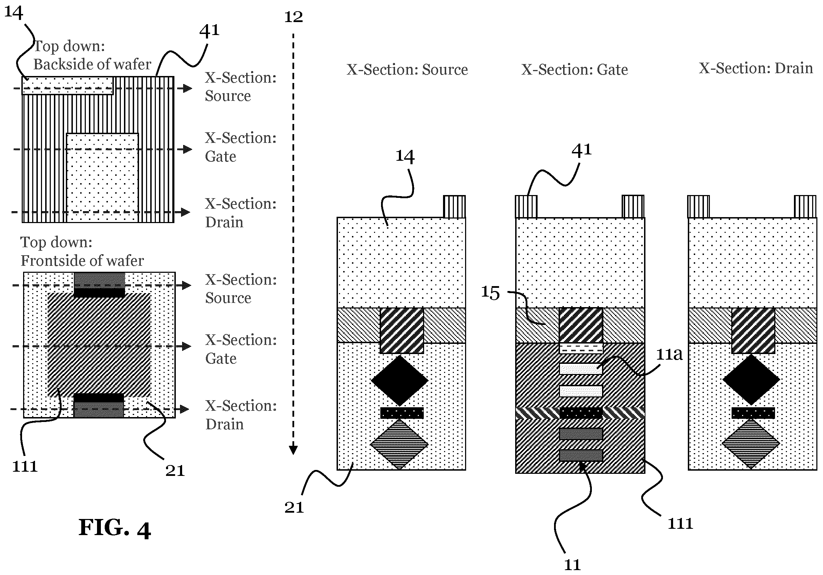

FIG. 4 shows a second step of the first processing sequence. In this second step, lithography is performed for the purpose of processing a source, gate, and drain contact for the particular transistor 11a in a self-aligned manner. The self-alignment comes from the sacrificial plug 27. For example, the lithography shape may be lines, as the subsequent etching is self-aligned to the sacrificial plug 27. A mask material 41 is selectively applied in the lithography, the mask material 41 being applied to the backside of the substrate 14.

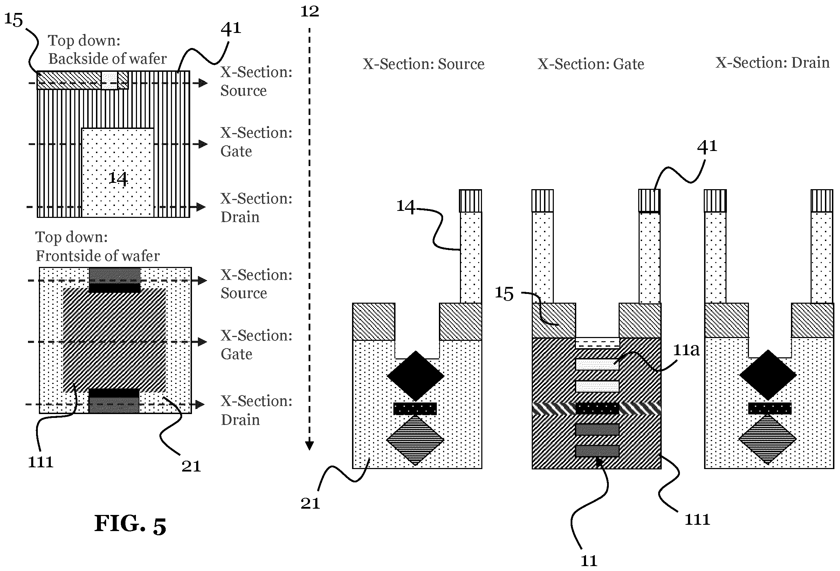

FIG. 5 shows a third step of the first processing sequence. In the third step, etching is performed using the lithography mask material 41 applied before. The etching is accordingly selective into the backside of the substrate 14. Also the sacrificial plug 27 in the STI 15 is etched, and the etching is stopped at the GAA structure 11 or respectively at a bottom dielectric isolation (BDI) 24.

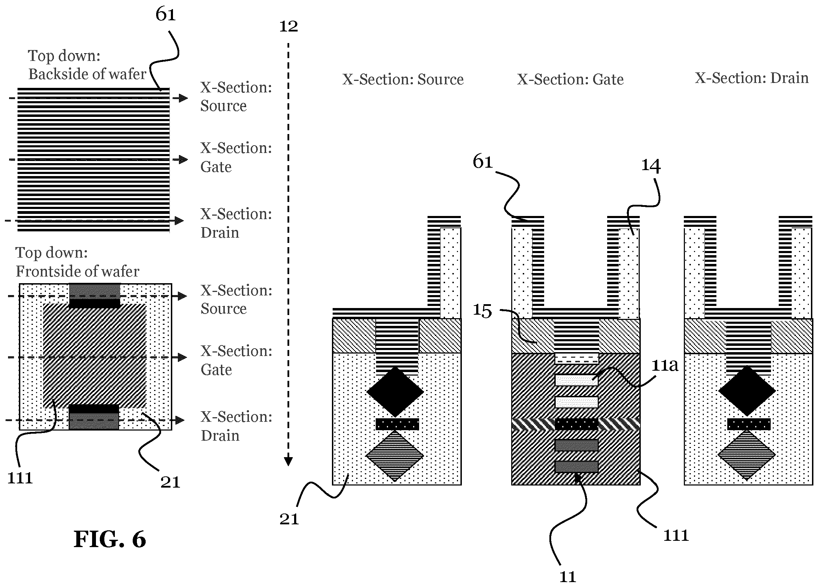

FIG. 6 shows a fourth step of the first processing sequence. In the fourth step, a metal 61 is deposited into the spaces resulting from the previous etching of the substrate 14 and the sacrificial plug 27, respectively. The metal 61 will be used, for instance, as the first metal 13a of the storage capacitor 13.

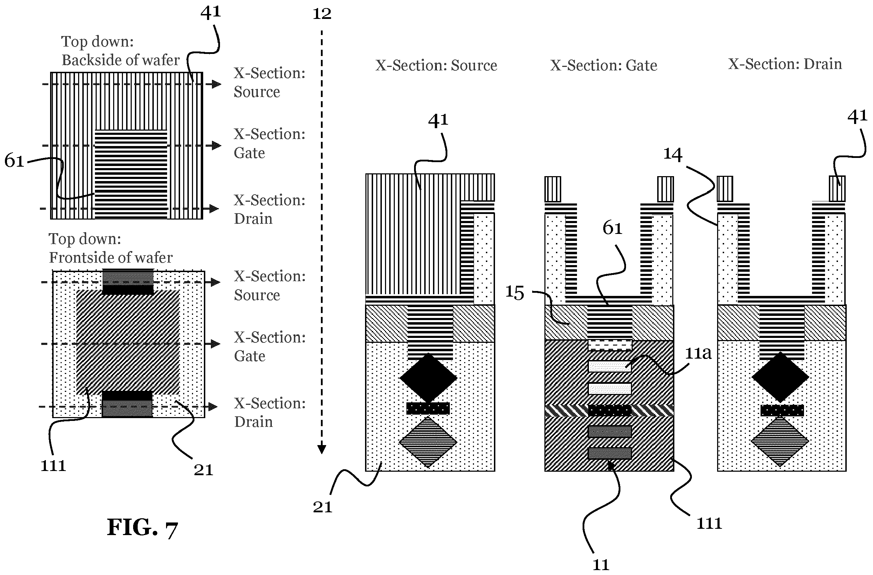

FIG. 7 shows a fifth step of the first processing sequence. In the fifth step, a further lithography is performed, wherein again a mask material 41 is applied to the backside of the substrate 14. This lithography step prepares, for example, for forming the dielectric material and the second metal of the storage capacitor 13, and for forming a bit line contact in the second region.

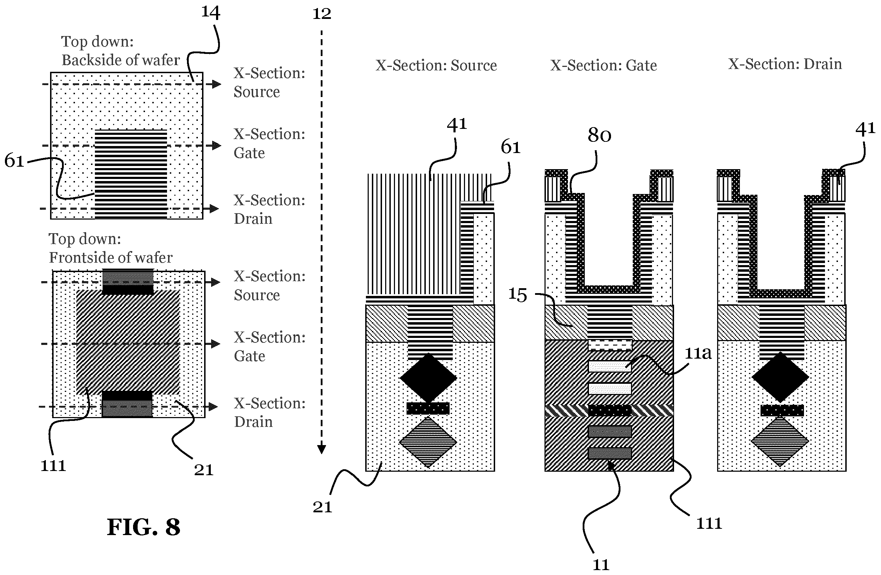

FIG. 8 shows a sixth step of the first processing sequence. In the sixth step, a dielectric material 80 is deposited. The deposition is also formed on the mask material 41. The dielectric material 80 will, for instance, be used as the dielectric material 13c of the storage capacitor 13.

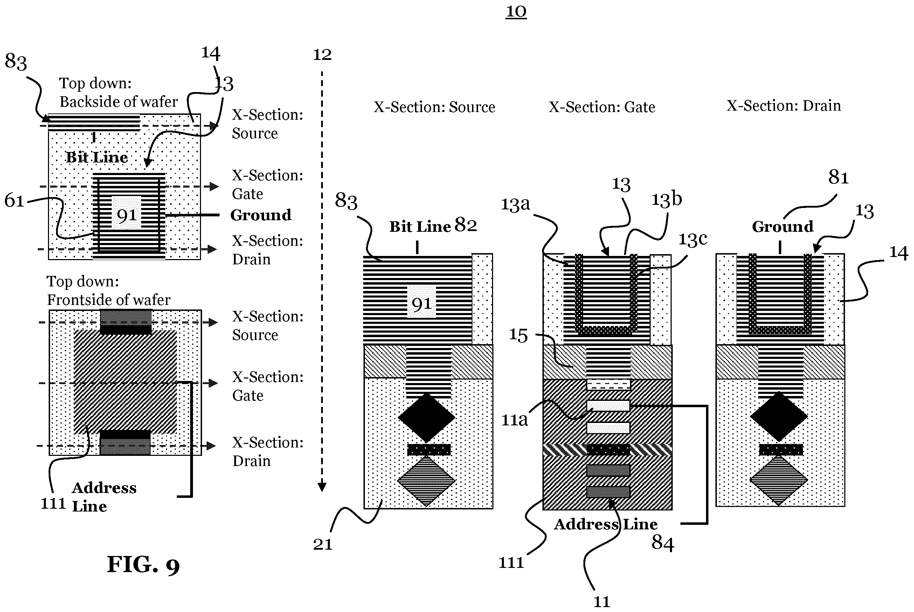

FIG. 9 shows a seventh step of the first processing sequence. In the seventh step a bulk metal deposition is carried out. The bulk metal 91 is used as the second metal 13b of the storage capacitor 13. With this, the storage capacitor 13 comprising the first metal 13a, the second metal 13b, and the dielectric material 13c separating the two metals 13a, 13b is completed. The bulk metal 91 is also used to form a bit line contact 83 in the second region. FIG. 9 shows also that the second metal 13c of the storage capacitor 13 is connected to a ground line 81. Further a bit line 82 is connected to the bit line contact 83. Further, an address line 84 is connected to a gate of the particular transistor 11a. At least a part of the address line 84 is arranged above the first region along the stacking direction 12, i.e., the gate connection is formed form the frontside of the substrate 14.

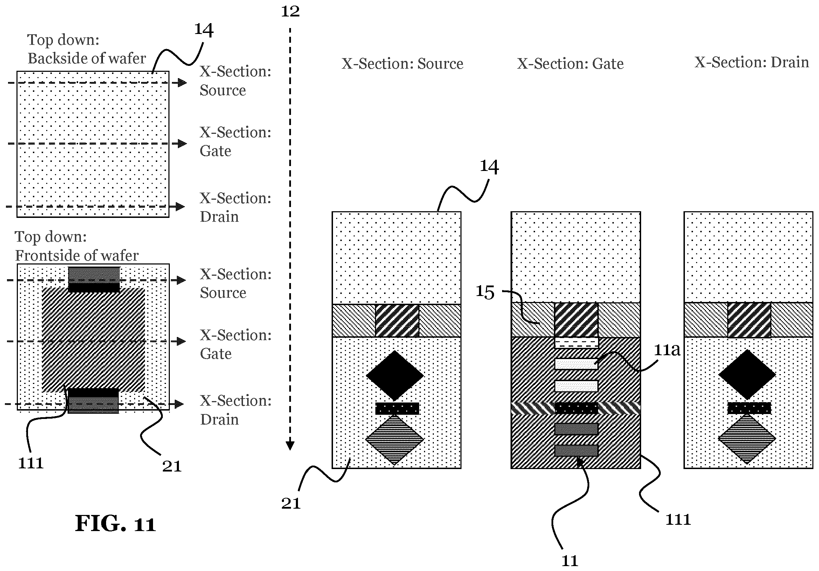

FIG. 10 shows an initial structure for starting the second processing sequence. The initial structure is shown in various views, particularly, in a top-down view of the backside of the substrate 14, in a top-down view of the front side of the substrate 14, in a view along a X-section through the source, in a view along a X-section through the gate, and in a view along the X-section through the drain. The same views are used in the FIGs. 11-17 to illustrate the second processing sequence. The initial structure of FIG. 10 corresponds more or less to the one shown in FIG. 2, so that a detailed description is not repeated.

FIG. 11 shows a first step of the second processing sequence. In the first step, the initial structure is flipped, and then a partial polish of the backside of the substrate 14 is performed.

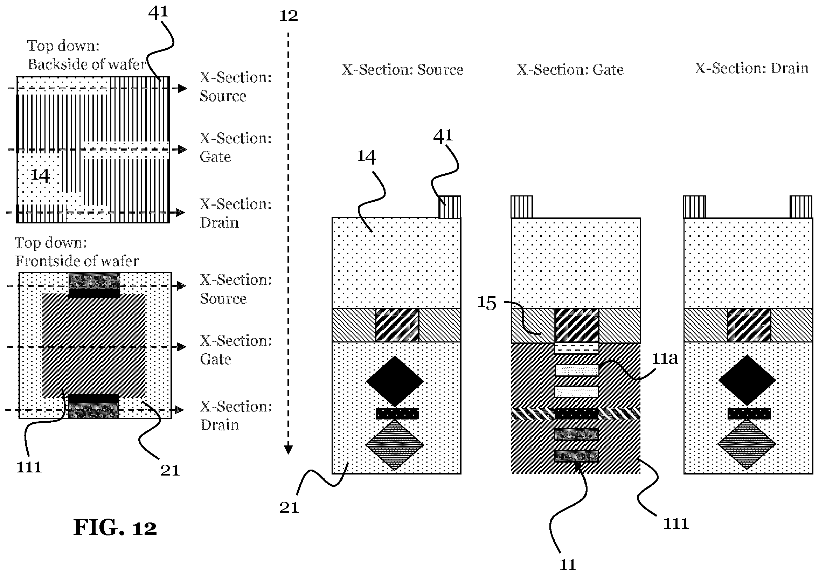

FIG. 12 shows a second step of the second processing sequence. In this second step, lithography is performed for the purpose of processing a source, gate, and drain contact of the particular transistor 11a in a self-aligned manner using the sacrificial plug 27, as described above. A mask material 41 is selectively applied in the lithography, wherein the mask material 41 is applied on the backside of the substrate 14. The lithography is different compared with FIG. 4.

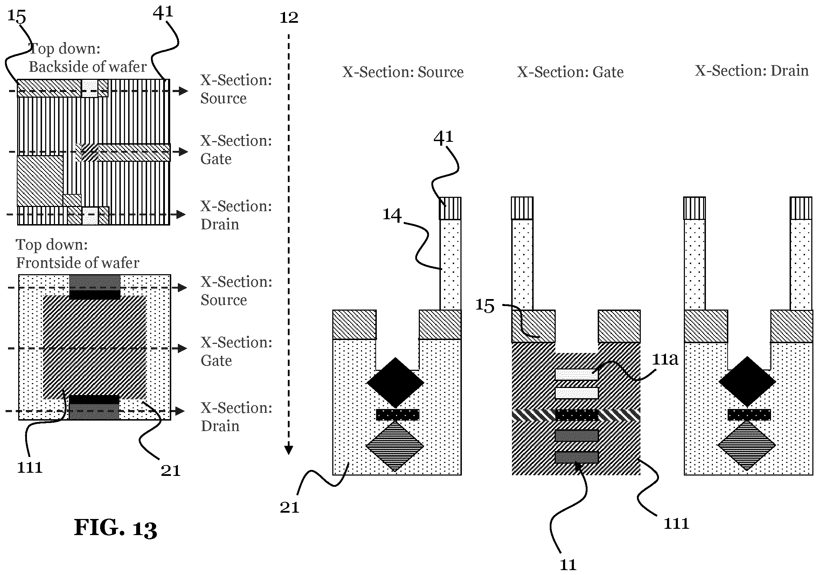

FIG. 13 shows a third step of the second processing sequence. In the third step, etching is performed using the lithography mask material 41. The etching is accordingly selective into the backside of the substrate 14. Also the sacrificial plug 27 in the STI 15 is etched, and the etching is stopped at the GAA structure 111 or a bottom dielectric isolation (BDI) 24, respectively.

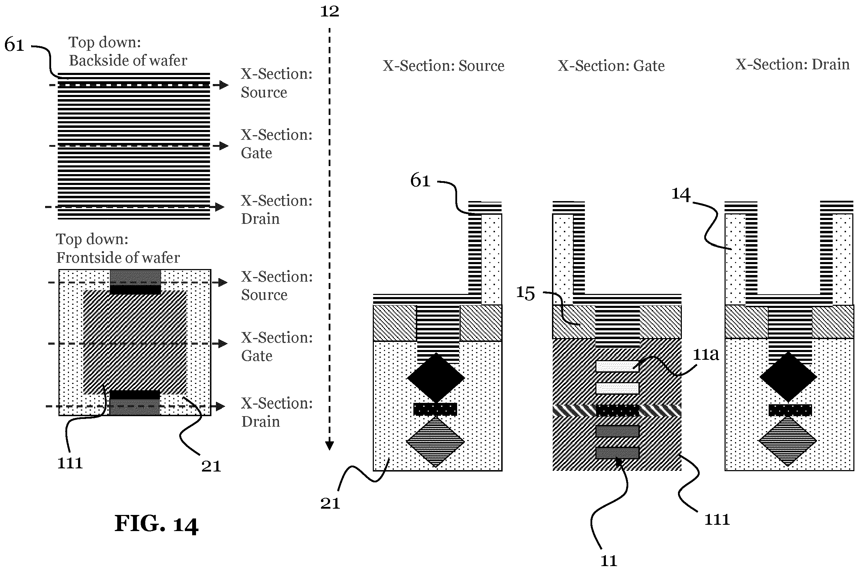

FIG. 14 shows a fourth step of the second processing sequence. In the fourth step, a metal 61 is deposited into the spaces resulting from the etching of the substrate 14 and the sacrificial plug 27, respectively. The metal 61 will be used, for instance, as the first metal 13a of the storage capacitor 13, and for a bit line contact and gate contact in the second region.

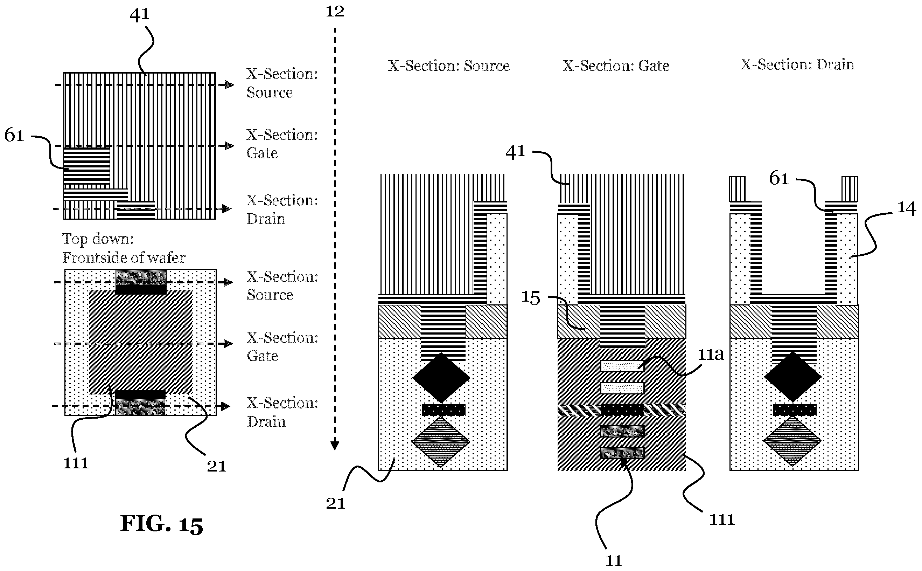

FIG. 15 shows a fifth step of the second processing sequence. In the fifth step, a further lithography is performed, wherein again a mask material 41 is applied to the backside of the substrate 14. This lithography prepares, for example, for forming the dielectric material and the second metal of the storage capacitor 13, and for forming a bit line contact and gate contact in the second region. The lithography is different compared to that in FIG. 7. While in FIG. 7 the lithography opens the mask over the gate and drain, in FIG. 15 the mask over the gate is not opened, to further use it as contact to an address line.

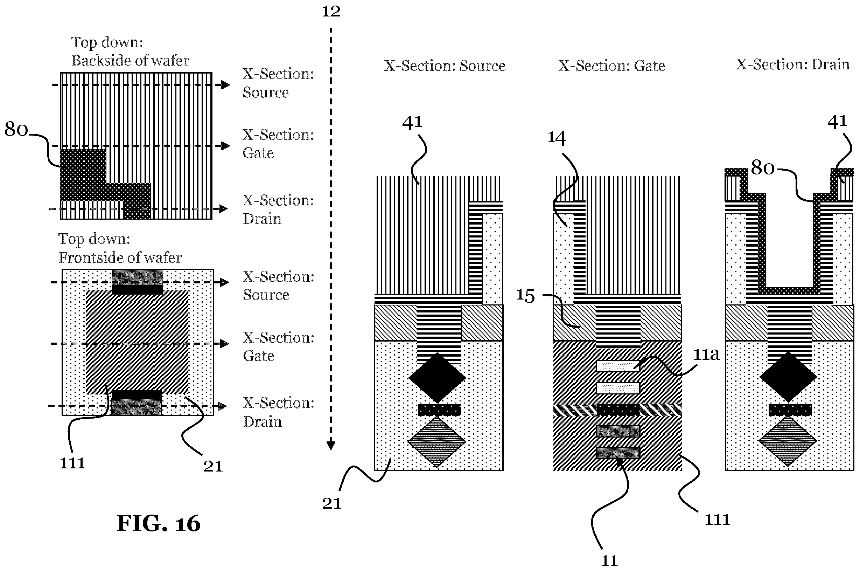

FIG. 16 shows a sixth step of the second processing sequence. In the sixth step, a dielectric material 80 is deposited. The dielectric material 80 will, for instance, be used as the dielectric material 13c of the storage capacitor 13. The dielectric material 80 is not formed on the mask material 14.

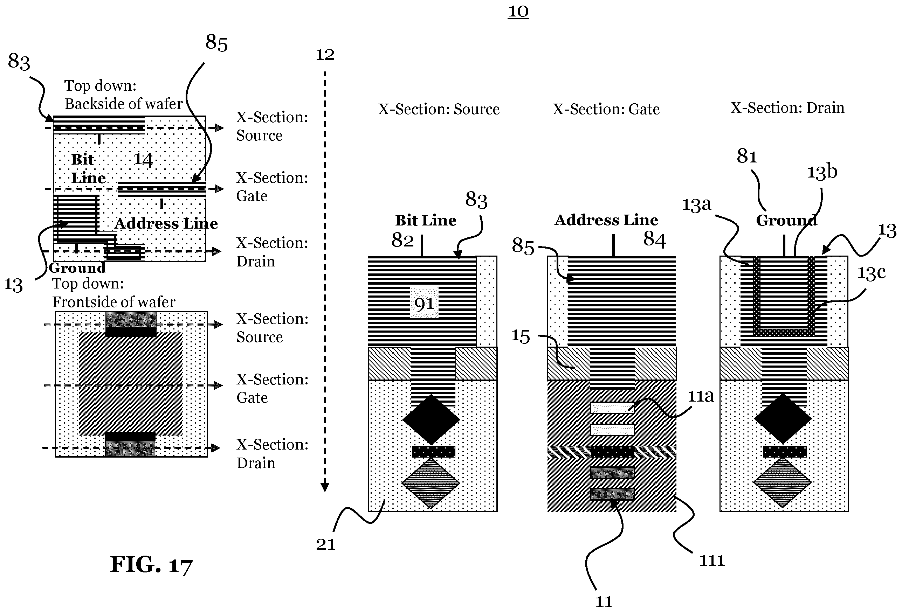

FIG. 17 shows a seventh step of the second processing sequence. In the seventh step a bulk metal deposition is carried out. The bulk metal 91 is used as the second metal 13b of the storage capacitor 13. With this, the storage capacitor 13 comprising the first metal 13a, the second metal 13b, and the dielectric material 13c separating the two metals 13a, 13b is completed. The bulk metal 91 is also used to form a bit line contact 83 in the substrate 14. The bulk metal 91 is also used to form a gate contact 85 in the second region. The gate contact 85 is connected to a gate of the particular transistor 11a. FIG. 17 shows also that the second metal 13c of the storage capacitor 13 is connected to a ground line 81. Further a bit line 82 is connected to the bit line contact 83. Further, an address line 84 is connected to a gate contact 85. The second region is arranged above at least a part of the address line 84 along the stacking direction 12. Thus, all connections - the bit line connection, gate connection, and ground connection - are formed from the backside of the substrate 14 in the second processing sequence.

FIG. 18 shows exemplary implementations and explanations of elements of the DRAM device 10 according to this disclosure. The substrate/wafer 14 maybe made of silicon. The GAA structure 111 may be made of HKMG+W. The stacked transistors 11 may be nanosheet transistors (i.e. may have nanosheet channels).

FIG. 19 shows a schematic circuit of the DRAM cell, and illustrates how the gate connections, ground connections, and bit line connections - to address line 84, ground line 81, and bit line 82 - in the FIGs. 9 and 17 are to form the DRAM cell.

In summary, this disclosure proposes a DRAM device 10 and exemplary fabrication sequences for the DRAM device 10. In the DRAM device, a DRAM may be integrated with a logic circuit. For instance, a storage capacitor of the DRAM may be embedded directly below a CFET structure, and a particular transistor of the CFET structure may be connected to the storage capacitor to form a DRAM cell.

In the claims as well as in the description of this disclosure, the word 'comprising' does not exclude other elements or steps and the indefinite article 'a' or 'an' does not exclude a plurality. A single element may fulfill the functions of several entities or items recited in the claims. The mere fact that certain measures are recited in the mutual different dependent claims does not indicate that a combination of these measures cannot be used in an advantageous implementation.

## Claims

1. An integrated dynamic random access memory, DRAM, device (10) including a DRAM and a logic circuit for controlling the DRAM, wherein the DRAM device (10) comprises:
a plurality of stacked transistors (11) arranged in a first region (111) of the DRAM device (10) one above another along a stacking direction (12);
a storage capacitor (13) arranged in a second region (14) of the DRAM device (10), wherein the first region (111) is arranged above the second region (14) along the stacking direction (12);
wherein a particular transistor (11a) of the plurality of stacked transistors (11) is connected to the storage capacitor (13) to form a DRAM cell of the DRAM; and
wherein the remaining transistors (11) of the plurality of stacked transistors (11) are part of the logic circuit.

2. The DRAM device (10) according to claim 1, wherein
the second region is a substrate layer (14) of the DRAM device (10), and the storage capacitor (13) is embedded in the substrate layer (14).

3. The DRAM device (10) according to claim 1 or 2, wherein
the particular transistor (11a) is connected with its drain to a first metal structure (13a) of the storage capacitor (13).

4. The DRAM device (10) according to claim 3, wherein the storage capacitor (13) further comprises
a second metal structure (13b), wherein the first metal structure (13a) is arranged above the second metal structure (13b) along the stacking direction (12); and
a dielectric layer (13c) separating and isolating the second metal structure (13b) from the first metal structure (13a).

5. The DRAM device (10) according to claim 4, wherein
the second metal structure (13b) is connected to a ground line of the DRAM device (10); and
the second region (14) is arranged above the ground line (81) along the stacking direction (12).

6. The DRAM device (10) according to one of the claims 1 to 5, further comprising:
a bit line contact (83) formed in the second region (14), connected to a source of the particular transistor (11a), and connected to a bit line (82) of the DRAM device (10);
wherein the second region (14) is arranged above at least a part of the bit line (82) along the stacking direction (12).

7. The DRAM device (10) according to one of the claims 1 to 6, wherein
a gate of the particular transistor (11a) is connected to an address line (84) of the DRAM device (10).

8. The DRAM device (10) according to claim 7, wherein
at least a part of the address line (84) is arranged above the first region (111) along the stacking direction (12).

9. The DRAM device (10) according to claim 7, further comprising
a gate contact (85) arranged in the second region (14), connected to the gate of the particular transistor (11a), and connected to the address line (84);
wherein the second region (14) is arranged above at least a part of the address line (84) along the stacking direction (12).

10. The DRAM device (10) according to one of the claims 1 to 9, wherein
the first region (111) and the second region (14) are monolithically integrated.

11. The DRAM device (10) according to one of the claims 1 to 10, wherein
the stacked transistors (11) are nanosheet transistors; and/or
the remaining transistors (11) comprise a set of n-type transistors and a set of p-type transistors of a complementary field effect transistor, CFET.

12. A method (190) for fabricating an integrated dynamic random access memory, DRAM, device (10) including a DRAM and a logic circuit for controlling the DRAM, wherein the method (190) comprises:
forming (191) a plurality of stacked transistors (11) in a first region (111) of the DRAM device (10) one above another along a stacking direction (12);
forming (192) a storage capacitor (13) in a second region (14) of the DRAM device (10), wherein the first region (111) is formed above the second region (14) along the stacking direction (12);
wherein a particular transistor (11a) of the plurality of stacked transistors (11) is connected to the storage capacitor (13) to form a DRAM cell of the DRAM; and
wherein the remaining transistors (11) of the plurality of stacked transistors (11) are formed as part of the logic circuit.

13. The method (190) according to claim 12, wherein
the second region is a substrate layer (14);
the first region (111) is formed on a front-surface of and above the substrate layer (14); and
the storage capacitor (13) is processed into the substrate layer (14) from a back-surface of the substrate layer (14).

14. The method (190) according to claim 12 or 13, wherein
the storage capacitor (13) is formed self-aligned with the particular transistor (11a), by etching a sacrificial plug (27) adjacent to a source and a drain of the transistor (11a), and by filling a first metal (13a) of the storage capacitor (13) into a space resulting from the etching of the sacrificial plug (27); and/or
the storage capacitor (13) is formed near the particular transistor (11a) instead of vias connected to the source and the drain of the particular transistor (11a) with the first metal (13a).

15. The method (190) according to one of the claims 12 to 14, wherein the method (190) further comprises
forming a bit line contact (83) and optionally a gate contact (85) in the second region (14);
wherein the bit line contact (83) is connected to a source of the particular transistor (11a), and the gate contact (85), if present, is connected to a gate of the particular transistor (11a).
